# EUROPÄISCHE PATENTSCHRIFT

(11) **EP 0 950 883 B1**
(45) Veröffentlichungstag und Bekanntmachung des Hinweises auf die Patenterteilung: **21.02.2007**
(21) Anmeldenummer: 99106863.6
(22) Anmeldetag: 07.04.1999
(51) Int. Cl.: G01L 5/28

(54) **Bremsprüfstand**
Testbench for brakes
Banc d'essai de freins

(30) Priorität: 15.04.1998 DE 29806722 U
(43) Veröffentlichungstag der Anmeldung: 20.10.1999
(73) Patentinhaber: SIEMENS AKTIENGESELLSCHAFT, 80333 München (DE)
(72) Erfinder: Haas, Dieter, 78052 Villingen-Schwenningen (DE)

(56) Entgegenhaltungen:
- US-A- 3 633 412
- US-A- 3 651 690
- US-A- 4 506 339

## Beschreibung

Die Erfindung betrifft einen Bremsenprüfstand nach dem Oberbegriff des Patentanspruches. Bremsenprüfstände sind in diversen Bauformen bekannt. In der Praxis hat sich jedoch bei der Ermittlung der Fahrzeuggeschwindigkeit bzw. Fahrzeugwegimpulszahl ein Problem ergeben, das diese Erfindung beheben will. Das Problem ergibt sich daraus, daß Bremsenprüfstände grundsätzlich langsam laufende Prüfstände sind. "Langsam laufend" bezeichnet hier eine Umlaufgeschwindigkeit der Rollen in der Größenordnung von ca. 3 km/h.

Bei der Ermittlung der Fahrzeuggeschwindigkeit bzw. Fahrzeugwegimpulszahl mit Hilfe eines Bremsenprüfstandes wird nach bekannten Meßprinzipien üblicherweise nur eine Seite der Fahrzeugachse eines auf dem Bremsenprüfstand befindlichen Fahrzeuges durch Rollen des Bremsenprüfstandes angetrieben. Infolge des einseitigen Antriebs ergibt sich über das Achsdifferential am Antriebsstrang des Fahrzeuges aber nur der halbe Wert der vom Bremsenprüfstand vorgegebenen Geschwindigkeit. Dies ist problematisch, weil in jüngerer Zeit im Fahrzeug die am Antriebsstrang anstehende Geschwindigkeit mit elektronischen, dynamisch arbeitenden Fahrzeugimpulsgebern abgegriffen und auf einem im Fahrzeug angeordneten Geschwindigkeitsregistriergerät, das z.B. als Fahrtschreiber ausgebildet sein kann, angezeigt wird. Die nach diesem Meßprinzip am Antriebsstrang des Fahrzeuges abgegriffene Geschwindigkeit reicht jedoch häufig nicht aus, um die Ansprechschwelle der Einrichtungen des Geschwindigkeitsregistriergerätes für die Registrierung oder Anzeige der Geschwindigkeit zu überwinden. Zumindest besteht ein hohes Risiko für eine fehlerhafte Anzeige. Im übrigen kann sich ein einseitiger Antrieb auch auf das Differential der Fahrzeugachse nachteilig auswirken. Angemerkt sei ferner, daß es für das Problem, das die hier beschriebene Erfindung behandelt, unerheblich ist, ob das Fahrzeug an der vom Bremsenprüfstand angetriebenen Fahrzeugachse einfach oder zwillingsbereift ist.

Um das eingangs geschilderte Problem bei der Ermittlung der Fahrzeuggeschwindigkeit bzw. Fahrzeugwegimpulszahl zu umgehen, könnte man zwar die Räder zu beiden Seiten derselben Fahrzeugachse durch die Rollen des Bremsenprüfstandes antreiben, jedoch wird üblicherweise bei einem Bremsenprüfstand ein der Umlaufgeschwindigkeit der Rollen proportionales Signal nur an einer Seite der Fahrzeugachse durch einen im Bremsenprüfstand angeordneten Impulsgeber abgegriffen. Da kein genauer Meßwert über die tatsächliche Umlaufgeschwindigkeit des auf der anderen Seite der Fahrzeugachse befindlichen Rades vorliegt, ist es nicht immer möglich, bei der Ermittlung der Fahrzeuggeschwindigkeit die gesetzlich vorgeschriebene Fehlergrenze von maximal +/- 2 % einzuhalten bzw. für ein im Fahrzeug angeordnetes Geschwindigkeitsregistriergerät, das mit Hilfe des Bremsenprüfstandes bezüglich seiner Registrier- und Anzeigegenauigkeit gemäß den gesetzlichen Vorschriften einzustellen ist, einen geringeren Wert als den maximal zulässigen Fehler zu garantieren.

Fehlerquellen, die trotz beidseitigen Antriebs maßgeblich das Meßergebnis beeinflussen, sind Schwankungen des Rollenantriebs während der Messung, unterschiedlich abgenutzte Rollen des Bremsenprüfstandes sowie unterschiedlich abgenutzte Reifen des Fahrzeugs und Eigenfehler des im Fahrzeug angeordneten Geschwindigkeitsregistriergerätes.

Die vorgenannten Fehlerquellen lassen sich durch einen Bremsenprüfstand mit den Merkmalen des Patentanspruches ausschalten. Es wird daher insbesondere vorgeschlagen, an den beiden Rollenpaaren, die die Räder einer gemeinsamen Fahrzeugachse antreiben, jeweils einen Impulsgeber vorzusehen, wobei jeder Impulsgeber ein Signal generiert, das der Umfangsgeschwindigkeit V₁ bzw. V₂ der jeweiligen angetriebenen Rolle proportional ist. Ebenso wird eine elektronische Schaltungsanordnung vorgesehen, der diese mit den beiden Impulsgebern aufgenommenen Signale zugeführt werden, wobei die Schaltungsanordnung dann zunächst prüft, ob von beiden Impulsgebern ein der Umfangsgeschwindigkeit V₁ bzw. V₂ proportionales Signal abgegeben wird. Wenn die Signale der Impulsgeber gleichzeitig vorliegen, ermittelt die Schaltungsanordnung aus diesen Signalen den arithmetischen Mittelwert v_{M} und gibt diesen Mittelwert v_{M} zur Weiterverarbeitung an ein Prüfgerät ab.

Anhand einer Prinzipskizze soll die vorgeschlagene Lösung nochmals kurz erläutert werden. Die **Figur** zeigt erfindungsrelevante Teile eines Bremsenprüfstandes mit mindestens zwei Rollenpaare 1, 2 und 3, 4, wobei jeweils eine Rolle 1 bzw. 3 jeden Rollenpaares 1, 2 bzw. 3, 4 von einem Motor 5, 6 des Bremsenprüfstandes angetrieben wird. Jedes Rollenpaar 1, 2 bzw. 3, 4 kann jeweils ein Rad 7, 8 eines auf dem Bremsenprüfstand befindlichen Fahrzeugs antreiben. Im Bremsenprüfstand sind mindestens zwei Rollenpaare 1, 2 bzw. 3, 4 derart angeordnet, daß sie auf diejenigen Räder 7, 8 des Fahrzeugs einwirken, die einer gemeinsamen Fahrzeugachse 9 angehören. Für die Anwendung der vorgeschlagenen Erfindung wird von einem Bremsenprüfstand ausgegangen, bei dem die auf eine gemeinsamene Fahrzeugachse 9 einwirkenden motorgetriebenen Rollen 1 bzw. 3 weder mechanisch noch sonstwie miteinander gekoppelt sind, sondern einzeln und unabhängig voneinander angetrieben werden.

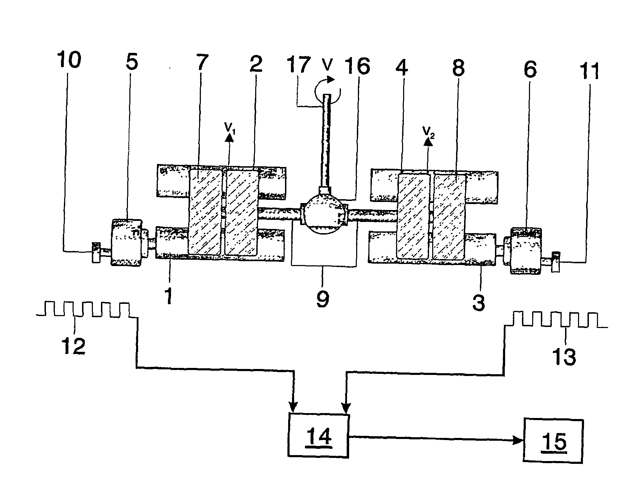

An den beiden Rollenpaaren 1, 2 bzw. 3, 4, die die Räder einer gemeinsamen Fahrzeugachse 9 antreiben, ist jeweils ein Impulsgeber 10, 11 vorgesehen, wobei jeder Impulsgeber 10, 11 ein Signal 12, 13 generiert, das der Umfangsgeschwindigkeit V₁ und V₂ der jeweiligen angetriebenen Rolle 1 bzw. 3 proportional ist. Das von den Impulsgebern 10, 11 generierte Signal 12, 13 ist in der Figur als eine Folge von Rechteckimpulsen dargestellt. Die Fahrzeugachse 9 kann, wie in dem in der Figur dargestellten Fall, ein Differential 16 enthalten, das die Drehbewegung der beiden Schenkel der Achse 9 auf den Antriebsstrang 17 des Fahrzeugs weiterleitet, so daß dort durch nicht dargestellte fahrzeugeigene Einrichtungen, wie z.B. durch einen elektronischen, dynamischen Fahrzeugimpulsgeber, ein der Fahrzeuggeschwindigkeit v proportionales Signal abgegriffen werden kann.

Zur richtigen Einstellung eines in dem Fahrzeug angeordneten Geschwindigkeitsregistriergerätes ist es erforderlich, die am Antriebsstrang 17 des Fahrzeugs abgreifbare Fahrzeuggeschwindigkeit v auf die mit dem Bremsenprüfstand tatsächlich eingestellte Umfangsgeschwindigkeit V₁ bzw. v₂ der Rollen abzugleichen. Für die Abweichung der mit dem Bremsenprüfstand vorgegebenen Geschwindigkeit und der im Fahrzeug vom Geschwindigkeitsregistriergerät angezeigten Geschwindigkeit hat der Gesetzgeber eine höchstzulässige Obergrenze festgelegt, so daß es das Bestreben ist, die vom Bremsenprüfstand vorgegebene Geschwindigkeit möglichst genau zu ermitteln, weil diese die Bezugsgröße für die Einstellungen der Registrier- und Anzeigeeinrichtungen des im Fahrzeug angeordneten Geschwindigkeitsregistriergerätes ist.

Ferner ist erfindungsgemäß in Verbindung mit dem Bremsenprüfstand eine elektronische Schaltungsanordnung 14 vorgesehen, der die Signale 12 und 13 der Impulsgeber 10, 11 zugeführt werden. Die Schaltungsanordnung 14 prüft nun zunächst, ob von beiden Impulsgebern 10 und 11 ein der Umfangsgeschwindigkeit V₁ bzw. V₂ proportionales Signal 12 bzw. 13 abgegeben wird. Diese Prüfung kann dadurch erfolgen, daß die Signale beider Impulsgeber 10 und 11 einem UND-Gatter zugeleitet werden. Wenn die Schaltungsanordnung 14 nun durch Abfrage des logischen Pegels am Ausgang des UND-Gatters feststellt, daß beide Signale 12 und 13 der Impulsgeber 10 und 11 gleichzeitig vorliegen, ermittelt sie in der Zeit des gleichzeitigen Vorliegens beider Signale 12 und 13 durch ein Rechenwerk, das als Mikroprozessor oder Mikrocontroller ausgebildet sein kann, den arithmetischen Mittelwert v_{M} aus den eingehenden Signalen 12 und 13. Danach gibt die Schaltungsanordnung 14 den ermittelten Mittelwert v_{M} z.B. als Impulssignal oder Digitalwort zur Weiterverarbeitung an ein Prüfgerät 15 ab, welches z.B. ein Abrolltest-Computer oder eine andere elektronische Werkstatteinrichtung sein kann.

## Patentansprüche

1. Bremsenprüfstand mit mindestens zwei Rollenpaare (1, 2 bzw. 3, 4),
a) wobei jeweils eine Rolle (1 bzw. 3) jeden Rollenpaares (1, 2 bzw. 3, 4) von einem Motor (5, 6) des Bremsenprüfstandes angetrieben wird,
b) wobei jedes Rollenpaar (1, 2 bzw. 3, 4) jeweils ein Rad (7, 8) eines auf dem Bremsenprüfstand befindlichen Fahrzeugs antreiben kann,
c) wobei im Bremsenprüfstand mindestens zwei Rollenpaare (1, 2 bzw. 3, 4) derart angeordnet sind, daß sie auf die Räder (7, 8) mit einer gemeinsamen Fahrzeugachse (9) einwirken, und
d) wobei die auf eine gemeinsamene Fahrzeugachse (9) einwirkenden motorgetriebenen Rollen (1 bzw. 3) ohne jedwede Kopplung unabhängig voneinander angetrieben werden,
**dadurch gekennzeichnet,**
e) **daß** an den beiden Rollenpaaren (1, 2 bzw. 3, 4), die die Räder einer gemeinsamen Fahrzeugachse (9) antreiben, jeweils ein Impulsgeber (10, 11) vorgesehen ist, wobei jeder Impulsgeber (10 bzw. 11) ein Signal (12 bzw. 13) generiert, das der Umfangsgeschwindigkeit (V₁ bzw. V₂) der jeweiligen angetriebenen Rolle (1 bzw. 3) proportional ist,
f) **daß** eine elektronische Schaltungsanordnung (14) vorgesehen ist, der diese Signale (12 und 13) zugeführt werden,
g) wobei die Schaltungsanordnung (14) prüft, ob von beiden Impulsgebern (10 und 11) ein der Umfangsgeschwindigkeit (v₁ bzw. v₂) proportionales Signal (12 bzw. 13) abgegeben wird,
h) wobei die Schaltungsanordnung (14) beim gleichzeitigen Vorliegen der Signale (12 und 13) der Impulsgeber (10 und 11) den arithmetischen Mittelwert (v_{M}) aus diesen Signalen (12 und 13) ermittelt und
i) wobei die Schaltungsanordnung (14) den ermittelten Mittelwert (v_{M}) zur Weiterverarbeitung an ein Prüfgerät (15) abgibt.

## Claims

1. Brake test stand having at least two pairs of rolls (1, 2 and 3, 4 respectively),
a) with one roll (1 and 3 respectively) from each pair of rolls (1, 2 and 3, 4 respectively) being driven by a motor (5, 6) of the brake test stand,
b) with each pair of rolls (1, 2 and 3, 4 respectively) being able to drive a respective wheel (7, 8) of a vehicle which is on the brake test stand,
c) with at least two pairs of rolls (1, 2 and 3, 4 respectively) being arranged in the brake test stand such that they act on those wheels (7, 8) having a common vehicle axle (9), and
d) with the motor-driven rolls (1 and 3 respectively) which act on a common vehicle axle (9) being driven independently of one another without any coupling,
**characterised**
e) **in that**, provided on each of the two pairs of rolls (1, 2 and 3, 4 respectively) which drive the wheels of a common vehicle axle (9) is a respective pulse encoder (10, 11), each pulse encoder (10 and 11 respectively) generating a signal (12 and 13 respectively) which is proportional to the peripheral speed (v₁ and V₂) of the respective driven roll (1 and 3 respectively),
f) **in that** an electronic circuit arrangement (14) is provided to which these signals (12 and 13) are supplied,
g) with the circuit arrangement (14) checking whether both pulse encoders (10 and 11) are emitting a signal (12 and 13 respectively) which is proportional to the peripheral speed (V₁ and V₂),
h) with the circuit arrangement (14), if the signals (12 and 13) of the pulse encoders (10 and 11) are present at the same time, determining from these signals (12 and 13) the arithmetic mean (V_{M}), and
i) with the circuit arrangement (14) emitting the determined mean value (v_{M}) to a test device (15) for further processing.

## Revendications

1. Banc d'essai de freins comportant au moins deux paires de rouleaux (1, 2 et, respectivement, 3, 4),
a) où un rouleau (1 et, respectivement, 3) de chaque paire de rouleaux (1, 2 et, respectivement, 3, 4) est entraîné par un moteur (5, 6) du banc d'essai de freins,
b) où chaque paire de rouleaux (1, 2 et, respectivement, 3, 4) peut entraîner une roue (7, 8) d'un véhicule se trouvant sur le banc d'essai de freins,
c) où, dans le banc d'essai de freins, au moins deux paires de rouleaux (1, 2 et, respectivement, 3, 4) sont disposées de telle manière qu'elles agissent sur les roues (7, 8) d'un axe commun (9) du véhicule et
d) où les rouleaux (1 et, respectivement, 3) entraînés par moteur agissant sur un axe commun (9) du véhicule sont entraînés indépendamment l'un de l'autre sans aucun couplage,
**caractérisé par le fait**
e) **que**, sur chacune des deux paires de rouleaux (1, 2 et, respectivement, 3, 4), qui entraînent les roues d'un axe commun (9) du véhicule, il est prévu un générateur d'impulsions (10, 11), chaque générateur d'impulsions (10 et, respectivement, 11) générant un signal (12 et, respectivement, 13), qui est proportionnel à la vitesse de rotation (v₁ et, respectivement, v₂) du rouleau respectif entraîné (1 et, respectivement, 3).
f) **qu'**il est prévu un circuit électronique (14) auquel ces signaux (12 et 13) sont appliqués,
g) le circuit (14) contrôlant si les deux générateurs d'impulsions (10 et 11) délivrent un signal (12 et, respectivement, 13) proportionnel à la vitesse de rotation (v₁ et, respectivement, v₂),
h) le circuit (14) déterminant, si les signaux (12 et 13) des générateurs d'impulsions (10 et 11) sont présents simultanément, la moyenne arithmétique (V_{M}) de ces signaux (12 et 13) et
i) le circuit (14) délivrant la moyenne déterminée (V_{M}) à un appareil de contrôle (15) en vue de son traitement ultérieur.
